# EUROPÄISCHE PATENTSCHRIFT

(11) **EP 1 014 568 B1**
(45) Veröffentlichungstag und Bekanntmachung des Hinweises auf die Patenterteilung: **20.12.2006**
(21) Anmeldenummer: 99124796.6
(22) Anmeldetag: 14.12.1999
(51) Int. Cl.: H03G 3/20

(54) **Verfahren und Vorrichtung zur Erfassung eines störungsbehafteten Empfangssignals**
Method and device for detecting a receive signal with noise
Méthode et dispositif de détection d'un signal reçu comportant du bruit

(30) Priorität: 24.12.1998 DE 19860214
(43) Veröffentlichungstag der Anmeldung: 28.06.2000
(73) Patentinhaber: ROBERT BOSCH GMBH, 70442 Stuttgart (DE)
(72) Erfinder: Hog, Norbert, 77815 Buehl (DE)

(56) Entgegenhaltungen:
- DE-A- 4 312 590
- DE-A- 4 403 221
- TIETZE; SCHENK: "Halbleiterschaltungstechnik" 1989 , SPRINGER VERLAG , HEIDELBERG XP002229252 * Seite 414, Zeile 3 - Seite 421, Zeile 6; Abbildungen 14.16,14.17 *

## Beschreibung

Die Erfindung betrifft ein Verfahren und eine Vorrichtung zur Erfassung eines störungsbehafteten Empfangssignals bei einem Regensensor eines Kraftfahrzeugs zur Bestimmung der Benetzung einer Windschutzscheibe.

### Stand der Technik

Häufig weist ein zu erfassendes Empfangssignal neben dem Nutzsignalanteil einen hohen Störsignalanteil auf. In solchen Fällen ist es erforderlich, den Nutzsignalanteil von dem Störsignalanteil zu trennen. Ein typischer Anwendungsfall sind Regensensoren für Kraftfahrzeuge, die den Benetzungsgrad einer Windschutzscheibe aufgrund der Intensität eines in die Windschutzscheibe eingekoppelten und aus dieser wieder ausgekoppelten Lichtsignals erfassen. Dabei kann aufgrund von Umgebungslichtquellen der Störlichtanteil sowohl bei Verwendung sichtbaren Lichts als auch von Infrarotlicht sehr hoch sein, im Extemfall ein Vielfaches des Nutzsignals betragen.

Aus der deutschen veröffentlichten Patentanmeldung DE 3336027 A1 ist ein optoelektronischer Empfänger bekannt, bei dem ein moduliertes Sendesignal in die Glasscheibe eingekoppelt und das an einer Photodiode empfangene Ausgangssignal erfaßt wird. Der optoelektronische Empfänger weist eine an einer Spannungsquelle angeschlossene Reihenschaltung aus der Photodiode und einer Vorrichtung zur Erzeugung einer dem Photodiodenstrom proportionalen Ausgangsspannung auf, bei welchem Empfänger zum Zwecke der Kompensierung von Störlichteinfall eine steuerbare Stromquelle und ein die Stromquelle in Abhängigkeit von Störlicht steuerndes Steuerglied vorgesehen ist. Dabei erfolgt die Steuerung der Stromquelle derart, daß eine vom Störlicht hervorgerufene Änderung des Photodiodenstroms im wesentlichen keine Änderung der Ausgangsspannung bewirkt und somit das Störlichtsignal unterdrückt ist. Der Stromverstärker benötigt jedoch einen teuren Operationsverstärker mit hochohmigem Eingang von mehr als 100 MΩ und einen hochohmigen Widerstand von ungefähr 10 MΩ als Rückkoppelwiderstand. Dieser hochohmige Wert bewirkt eine große Empfindlichkeit der Schaltung gegenüber Umwelteinflüssen wie Feuchtigkeit oder Schmutz. Darüber hinaus ist ein zusätzlicher Transistor zur Fremdlichtkompensation notwendig. Die bekannte Schaltung ist daher insgesamt aufwendig und teuer. Trotzdem bleibt ein stationärer Fehler bei der Fremdlichtunterdrückung erhalten.

Aus der DE 44 03 221 A1 ist eine Anordnung zum Erkennen einer Benetzung einer benetzbaren äußeren Oberfläche bekannt. Es wird dabei vorgeschlagen, mittels mehrerer Sender Nutzsignale so in eine Windschutzscheibe einzukoppeln, dass diese Signale schließlich von einem gemeinsamen Empfänger empfangen werden können. Die Sender werden zeitlich versetzt betrieben, und die beim Empfänger zeitlich versetzt eintreffenden Signale werden verglichen. Stellt sich zwischen den zeitlich beabstandeten Signalen ein Unterschied ein -ausgelöst durch eine Benetzung der Windschutzscheibe-, so wird mittels Stromstellgliedern mindestens ein Sender so beeinflusst, dass der ermittelte Unterschied gegen Null geht. Es ist aber nachteilig, dass die vorgeschlagene Vorrichtung sehr aufwendig ist, insbesondere, da sie sowohl bei Nacht als auch bei hellem Sonnenschein (Störsignalanteil) funktionieren soll und daher für einen großen Arbeitsbereich ausgelegt werden muss.

### Vorteile der Erfindung

Das erfindungsgemäße Verfahren gemäß Anspruch 1 beziehungsweise die erfindungsgemäße Vorrichtung gemäß Anspruch 4 erreicht die Trennung des Nutzsignalanteils von dem Störsignalanteil durch eine Rückkoppelschleife, die das Ausgangssignal mit einer festgelegten Zeitkonstante auf einen festgelegten Referenzspannungspegel regelt. Dabei ist die Pulsdauer eines in das Übertragungsmedium eingekoppelten Sendesignals kleiner als die Zeitkonstante der Rückkoppelschaltung, so daß niederfrequente Fremdsignale ausgeregelt werden, nicht jedoch das gepulste Nutzsignal, das am Ausgang anliegt. Das erfindungsgemäße Verfahren und die erfindungsgemäße Vorrichtung haben den Vorteil, daß keine Stromverstärker mit hochohmigen Widerständen erforderlich sind, wodurch die Schaltung robust gegen Umwelteinflüsse ist. Der Aufbau ist insgesamt einfach und preiswert zu realisieren und der Regelkreis ist einfach auf Stabilität einzustellen.

Vorzugsweise wird die Rückkoppelschaltung durch einen PI-Regler realisiert, dessen nicht-invertierender Eingang mit einer festgelegten Versorgungsspannung und dessen invertierender Eingang über einen Tiefpaßfilter mit dem Ausgang eines Impedanzwandlers verbunden ist. Der PI-Regler sorgt dabei für eine stationäre Genauigkeit bei der Unterdrückung des Fremdlichtes, da die Ausgangsspannung immer auf eine festgelegte Referenzspannung geregelt wird. Als Impedanzwandler kann ein preiswerter Typ mit niedrigem Eingangswiderstand verwendet werden.

### Zeichnung

Die Erfindung wird im folgenden anhand eines Ausführungsbeispiels unter Bezugnahme auf die Zeichnungen im Detail erläutert, in denen
- Figur 1: ein schematisches Regelkreis-Blockschaltbild zur Illustration der Funktionsweise des erfindungsgemäßen Verfahrens und der erfindungsgemäßen Vorrichtung zeigt;
- Figur 2: ein Schaltbild eines Ausführungsbeispiels der erfindungsgemäßen Vorrichtung zeigt; und
- Figur 3: schematisch ein gepulstes Sendesignal zeigt.

### Beschreibung von Ausführungsbeispielen

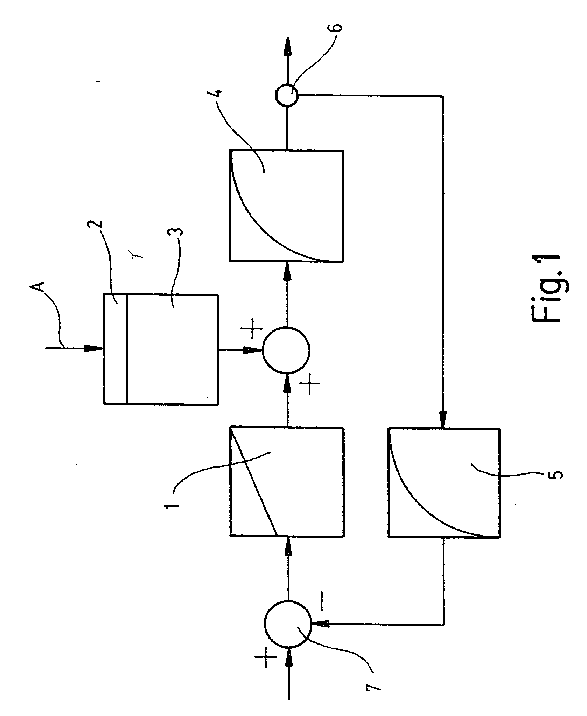

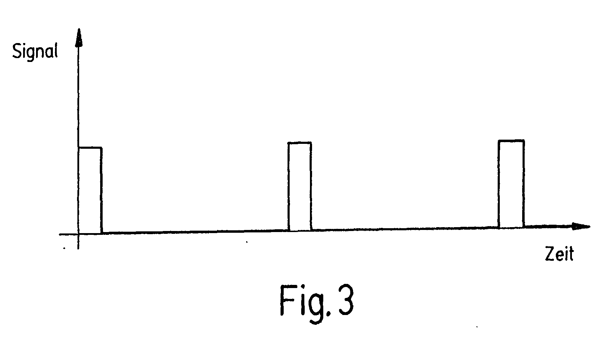

Figur 1 ist ein schematisches Blockschaltbild eines bevorzugten Regelkreises des erfindungsgemäßen Verfahrens beziehungsweise der erfindungsgemäßen Vorrichtung. Das zu detektierende Lichtsignal (Pfeil A) fällt auf den Photodetektor 2 und erzeugt einen der Lichtintensität proportionalen Lichtstrom. Dieser verursacht an dem P-Glied 3 einen Spannungsabfall, der wiederum dem Lichtstrom proportional ist. In dem Impedanzwandler 4 werden die Ausgangssignale des P-Gliedes 3 und eines PI-Reglers 1 addiert, wie durch die "+-Symbole" symbolisiert ist. Das Ausgangssignal des Impedanzwandlers 4 liegt am Ausgangsanschluß 6 an und wird über ein Tiefpaßfilter 5 dem PI-Regler 1 invertiert zurückgekoppelt. Am Knoten 7 liegt ein konstanter Fremdsignal-Sollwert (Pluseingang) an, welchem mit negativen Vorzeichen das Fremdsignal-Istwertsignal von dem Tiefpaßfilter überlagert wird. Der PI-Regler 1 regelt seinen Ausgang so an, daß die Differenz der Ausgangsspannung des Tiefpaßfilters 5 und der Fremdsignal-Sollwert zu Null ausgeregelt wird, das heißt am Ausgang des PI-Reglers die gleiche Spannung anliegt wie am positiven Eingang des Knotens 7. Das bedeutet, daß auch die am Ausgangsanschluß 6 anliegende Ausgangsspannung im stationären Zustand konstant und ohne jeglichen Fremdsignalanteil ist. Aufgrund des Tiefpaßfilters 5 gelingt es der Rückkoppelregelung jedoch nicht, kurze Signale unterhalb der Zeitkonstante des Tiefpaßfilters 5 auszuregeln. Das heißt, kurze Lichtsignale A erzeugen einen dazu proportionalen Spannungspuls am Ausgangsanschluß 6, während niederfrequentere Störsignale ausgeregelt werden. Zur störunterdrückten Messung von Lichtsignalen, die beispielsweise den Benetzungsgrad einer Windschutzscheibe eines Kraftfahrzeuges angeben, werden daher Nutzsignalpulse mit einer Dauer erzeugt, die kleiner ist als die Zeitkonstante des Tiefpaßfilters 5, so daß die Nutzsignalpulse nicht ausgeregelt werden und Änderungen der am Ausgangsanschluß 6 anliegenden Spannung Änderungen des Nutzsignals wie beispielsweise eine Änderung des Benetzungsgrades aufgrund eines Regenschauers oder dergleichen reflektieren. Eine typische Nutzsignalfolge ist in Figur 3 dargestellt. Kurze Lichtpulse einer Dauer von beispielsweise 100 *µ*s werden in Abständen von 1 ms ausgesandt. Selbstverständlich kann die Form, Dauer und Frequenz der Pulse vom Fachmann dem jeweiligen Anwendungsfall entsprechend angepaßt werden.

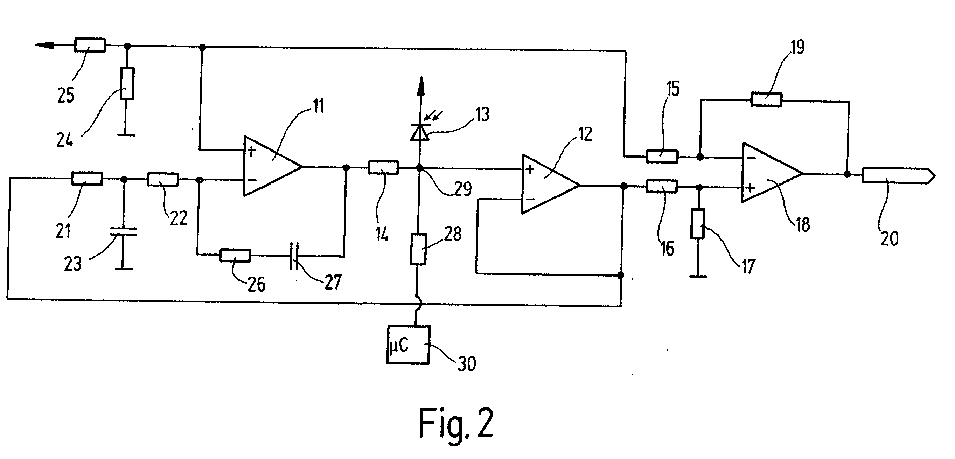

Figur 2 zeigt ein Schaltbild einer erfindungsgemäßen Vorrichtung zur Erfassung eines störungsbehafteten Empfangssignals. Die Einrichtung zur Erzeugung der Signalpulse, wie sie beispielhaft in Figur 3 dargestellt sind, ist nicht gezeigt. Zur Erzeugung von Lichtpulsen kann eine bekannte Leuchtdiode verwendet werden, die beispielsweise im sichtbaren oder im Infrarot-Bereich arbeitet.

Das zu erfassende Lichtsignal fällt auf den Photodetektor 13 und erzeugt am Widerstand 14 eine der Lichtintensität proportionale Spannung, welche durch den Impedanzwandler 12 impedanzgewandelt wird. Der Ausgang des Impedanzwandlers ist über ein Tiefpaßfilter 21, 22, 23 mit dem invertierenden Eingang eines PI-Reglers bestehend aus einem Operationsverstärker 11 mit Rückkoppelwiderstand 26 und Rückkoppelkondensator 27 verbunden. Der nicht-invertierende Eingang des Operationsverstärkers 11 ist über einen Spannungsteiler 24, 25 mit einer Versorgungsspannung (Dreiecksymbol) verbunden, so daß der nicht-invertierende Eingang des PI-Reglers 11 immer auf einer konstanten Spannung, beispielsweise 2 Volt liegt. Der PI-Regler steuert seinen Ausgang zum Treiben des Widerstands 14 so an, daß die Differenz der Ausgangsspannung des Tiefpasses (Minus-Eingang) und dem Fremdsignal-Sollwert (PlusEingang) auf Null ausgeregelt wird, das heißt am Ausgang die Referenzspannung 2 Volt anliegt. Am Ausgang des Impedanzwandlers 12 liegt im ausgeregelten Zustand dann ebenfalls die Referenzspannung von 2 Volt an. Der Verstärker 18, 19 beseitigt mittels des Eingangswiderstandes 15 und des Spannungsteilers 16, 17 den Spannungs-Offset von 2 Volt und verstärkt das Nutzsignal, das heißt die am Ausgang des Impedanzwandlers 12 anliegende Spannungsdifferenz zu 2 Volt, um einen konstanten Faktor, beispielsweise Faktor 3. Das verstärkte Nutzsignal liegt am Ausgang 20 an.

Fakultativ kann am Punkt 29 zwischen dem Widerstand 14, der Diode 13 und dem Eingang des Impedanzwandlers 12 eine erste Anschlußklemme eines Widerstands 28 angeschlossen sein, dessen zweite Anschlußklemme auf Masse gezogen oder hochohmig gemacht werden kann, zum Beispiel mit Hilfe eines Mikrocontrollers 30.

Wenn der Widerstand auf Masse gezogen wird, sind die Spannungsänderungen am Punkt 29 infolge einer Änderung des Lichteinfalls auf die Photodiode 13 geringer, als wenn der Widerstand 28 hochohmig (oder nicht vorhanden) ist. Der Meßbereich der Schaltung ist dadurch vergrößert, beziehungsweise ihre Empfindlichkeit verringert.

Der Widerstand 28 ermöglicht so zum Beispiel die Anpassung der erfindungsgemäßen Erfassungsvorrichtung an unterschiedlich getönte Scheiben ohne Änderungen an der Schaltung.

Wie schon in dem regelungstechnischen Blockschaltbild von Figur 1 erläutert wurde, hat die Rückkoppelschleife aufgrund des Tiefpaßfilters 21, 22, 23 eine festgelegte Zeitkonstante, die entsprechend dem jeweiligen Einsatzgebiet des Detektors wählbar ist. Niederfrequentere (Stör-)Signale werden ausgeregelt, während kurze Signalpulse, wie beispielsweise die in Figur 3 schematisch gezeigten Signalpulse im wesentlichen ungeschwächt am Ausgang des Impedanzwandlers 12 anliegen und anschließend durch den Verstärker verstärkt dem Anschluß 20 zugeführt werden.

Das erfindungsgemäße Verfahren und die erfindungsgemäße Vorrichtung zur Erfassung eines störungsbehafteten Empfangssignals ermöglicht mit einer einfachen, preiswerten und stabilen Schaltung eine wirkungsvolle Störsignalunterdrückung, bei der auch stationäre Störsignale, wie beispielsweise konstanter Sonnenlichteinfall auf die Windschutzscheibe, sicher unterdrückt werden und nicht zur Übersteuerung einer Eingangs- oder Verstärkungsstufe führen. Es sind insgesamt nur preiswerte Bauelemente notwendig; problematische, sehr hochohmige Widerstände sind nicht erforderlich.

## Patentansprüche

1. Verfahren für einen Regensensor eines Kraftfahrzeugs zur Bestimmung der Benetzung einer Windschutzscheibe, wobei
- ein Sendesignal, aufweisend
- ein gepulstes Nutzsignal mit einer festgelegten Pulsdauer, in ein Übertragungsmedium eingekoppelt wird,
- ein kontinuierliches Empfangssignal, aufweisend einen Nutzsignalanteil und einen Störsignalanteil, aus dem Übertragungsmedium ausgekoppelt wird, und
- das Empfangssignal in eine zugehörige Ausgangsspannung umgesetzt wird,
**dadurch gekennzeichnet, dass** das Empfangssignal an einem Widerstand eine Spannung erzeugt, welche durch einen Impedanzwandler (4;12) in die Ausgangsspannung umgesetzt wird, wobei die Ausgangsspannung durch eine Rückkoppelschaltung auf einen konstanten Referenzspannungspegel geregelt wird, und wobei für die Rückkoppelschaltung ein PI-Regler (1;11,26,27) verwendet wird, dem an seinem nicht-invertierenden Eingang eine festgelegte Versorgungsspannung vorgegeben und dem an seinem invertierenden Eingang über einen Tiefpassfilter (5;21,22,23) die Ausgangsspannung zugeführt wird, und der seinen Ausgang zum Treiben des Widerstandes so ansteuert, dass die Differenz der Tiefpassfilter-Ausgangsspannung und der Versorgungsspannung auf Null ausgeregelt wird, und wobei dem Tiefpassfilter eine Zeitkonstante vorgegeben wird, die größer ist als die Pulsdauer des Nutzsignals, sodass der dem Nutzsignalanteil entsprechende Anteil der Ausgangsspannung auf die Regielung des Referenzspannungspegels keinen Einfluss nimmt.

2. Verfahren nach Anspruch 1, **dadurch gekennzeichnet, daß** die Pulsdauer des Sendesignals ca. 100 *µ*s, die Periodendauer des Sendesignals ca. 1000 *µ*s und die Zeitkonstante der Regelung ca. 3 *µ*s beträgt.

3. Verfahren nach Anspruch 1 oder 2, **dadurch gekennzeichnet, daß** das Übertragungsmedium aus Glas besteht und Sendesignal und Empfangssignal Lichtsignale sind.

4. Vorrichtung für einen Regensensor eines Kraftfahrzeugs zur Bestimmung der Benetzung einer Windschutzscheibe, wobei die Vorrichtung aufweist:
- eine Sendeeinrichtung zur Einkopplung eines gepulsten Sendesignals mit einer festgelegten Pulsdauer in ein Übertragungsmedium,
- eine Empfangseinrichtung (2;13) zur Erfassung eines kontinuierlichen Empfangssignals, aufweisend einen Nutzsignalanteil und einen Störsignalanteil, aus dem Übertragungsmedium,
- eine Umsetzeinrichtung (4;12) zur Umsetzung des Empfangssignals in eine zugehörige Ausgangsspannung,
**dadurch gekennzeichnet, dass** die Umsetzeinrichtung (4;12) zur Regelung der Ausgangsspannung auf einen konstanten Referenzspannungspegel eine Rückkoppeschaltung mit einem Pl-Regler (1;11,26,27) aufweist, dessen nicht-invertierender Eingang mit einer festgelegten Versorgungsspannung und dessen invertierender Eingang über einen Tiefpassfilter (5;21,22,23) mit der Ausgangsspannung der Umsetzeinrichtung (4;12) verbunden ist, wobei der PI-Regler (1;11,26,27) mit seinem Ausgang über einen mit der Empfangseinrichtung verbundenen Widerstand (14) mit dem Eingang der Umsetzeinrichtung (4;12) in Verbindung steht, wobei die Pulsdauer des Nutzsignals kleiner ist als eine Zeitkonstante des Tiefpassfilters (5;21,22,23) der Rückkoppelschaltung (1,5;11,21,22,23,26,27), so dass der dem Nutzsignalanteil entsprechende Anteil der Ausgangsspannung auf die Regielung des Referenzspannungspegels keinen Einfluss nimmt.

5. Vorrichtung nach Anspruch 4, **dadurch gekennzeichnet, daß** die RC-Zeitkonstante des Tiefpaßfilters zwischen 3 und 5 ms beträgt.

6. Vorrichtung nach einem der Ansprüche 4 bis 5, **dadurch gekennzeichnet, daß** die Sendeeinrichtung eine Leuchtdiode ist, die im sichtbaren oder IR-Bereich arbeitet.

7. Vorrichtung nach einem der Ansprüche 4 bis 6, **dadurch gekennzeichnet, daß** die Empfangseinrichtung (2;13) ein Photosensor ist.

8. Vorrichtung nach einem der Ansprüche 4 bis 7, **dadurch gekennzeichnet, daß** die Umsetzeinrichtung (4;12) ein Impedanzwandler ist.

9. Vorrichtung nach Anspruch 8, **dadurch gekennzeichnet, daß** der Impedanzwandler ein Operationsverstärker mit einer vorgegebenen Verstärkung ist.

10. Vorrichtung nach einem der Ansprüche 4 bis 9, **gekennzeichnet durch** Mittel (28,30) zum Umschalten der Empfindlichkeit der Vorrichtung.

11. Regensensor, aufweisend eine Vorrichtung für einen Regensensor nach einem der Ansprüche 4 bis 10 zur Erfassung des Benetzungsgrades einer Windschutzscheibe eines Kraftfahrzeuges.

## Claims

1. Method for a rain sensor for a motor vehicle for determination of wetting of a windscreen, in which
- a transmission signal, having a pulsed useful signal with a fixed pulse duration is injected to a transmission medium,
- a continuous received signal, having a useful signal component and having an interference signal component, is output from the transmission medium, and
- the received signal is converted to an associated output voltage,
**characterized in that** the received signal produces a voltage across a resistance, which voltage is converted by an impedance converter (4; 12) to the output voltage, with the output voltage being regulated by a feedback circuit at a constant reference voltage level, and with a PI regulator (1; 11, 26, 27) being used for the feedback circuit, for which PI regulator (1; 11, 26, 27) a fixed supply voltage is predetermined at its non-inverting input, and to which the output voltage is supplied, to its inverting input, via a low-pass filter (5; 21, 22, 23), and which drives its output for driving the resistance such that the difference between the low-pass filter output voltage and the supply voltage is regulated at zero, and with a time constant being predetermined for the low-pass filter, which is longer than the pulse duration of the useful signal, so that that component of the output voltage which corresponds to the useful signal component has no influence on the regulation of the reference voltage level.

2. Method according to Claim 1, **characterized in that** the pulse duration of the transmission signal is approximately 100 µs, the period duration of the transmission signal is approximately 1000 µs, and the time constant of the regulation is approximately 3 µs.

3. Method according to Claim 1 or 2, **characterized in that** the transmission medium is composed of glass, and the transmission signal and the received signal are light signals.

4. Apparatus for a rain sensor for a motor vehicle for determination of wetting of a windscreen, with the apparatus having:
- a transmitting device for injection of a pulsed transmission signal with a fixed pulse duration into a transmission medium,
- a receiving device (2; 13) for detection of a continuous received signal, having a useful signal component and an interference signal component from the transmission medium,
- a conversion device (4; 12), for conversion of the received signal to an associated output voltage,
**characterized in that** the conversion device (4; 12) has a feedback circuit with a PI regulator (1; 11, 26, 27) for regulation of the output voltage at a constant reference voltage level, the non-inverting input of which PI regulator (1; 11, 26, 27) is connected to a fixed supply voltage and the inverting input of the PI regulator (1; 11, 26, 27) is connected via a low-pass filter (5; 21, 22, 23) to the output voltage from the conversion device (4; 12), with the output of the PI regulator (1; 11, 26, 27) being connected via a resistance (14) which is connected to the receiving device, to the input of the conversion device (4; 12), with the pulse duration of the useful signal being shorter than a time constant of the low-pass filter (5; 21, 22, 23) in the feedback circuit (1, 5; 11, 21, 22, 23, 26, 27) such that that component of the output voltage which corresponds to the useful signal component has no influence on the regulation of the reference voltage level.

5. Apparatus according to Claim 4, **characterized in that** the RC time constant of the low-pass filter is between 3 and 5 ms.

6. Apparatus according to one of Claims 4 or 5, **characterized in that** the transmitting device is a light-emitting diode which operates in the visible or IR range.

7. Apparatus according to one of Claims 4 to 6, **characterized in that** the receiving device (2; 13) is a photosensor.

8. Apparatus according to one of Claims 4 to 7, **characterized in that** the conversion device (4; 12) is an impedance converter.

9. Apparatus according to Claim 8, **characterized in that** the impedance converter is an operational amplifier with a predetermined gain.

10. Apparatus according to one of Claims 4 to 9, **characterized by** means (28, 30) for switching the sensitivity of the apparatus.

11. Rain sensor, having an apparatus for a rain sensor according to one of Claims 4 to 10 for detection of the degree of wetting of a windscreen of a motor vehicle.

## Revendications

1. Procédé applicable à un capteur de pluie d'un véhicule automobile pour déterminer le mouillage d'un pare-brise selon lequel :
- on injecte un signal d'émission comprenant un signal utile, pulsé, avec une durée d'impulsion fixe, dans un milieu de transmission,
- on découple un signal de réception continu ayant une partie de signal utile et une partie de signal parasite, à partir du milieu de transmission, et
- on convertit le signal de réception en une tension de sortie correspondante,
**caractérisé en ce que**
le signal de réception génère une tension aux bornes d'une résistance, cette tension étant convertie par un convertisseur d'impédance (4, 12) en une tension de sortie,
la tension de sortie étant régulée par un circuit de réaction sur un niveau de tension de référence constant et
le circuit de réaction utilise un régulateur PI (1, 11, 26, 27) dont l'entrée non inversée reçoit une tension d'alimentation fixe et dont l'entrée inversée reçoit la tension de sortie par l'intermédiaire d'un filtre passe-bas (5, 21, 22, 33) et sa sortie est commandée pour piloter la résistance de façon que la différence entre la tension de sortie du filtre passe-bas et la tension d'alimentation soit régulée sur zéro et
le filtre passe-bas a une constante de temps supérieure à la durée impulsionnelle du signal utile de façon que la composante de la tension de sortie correspondant à la composante de signal utile n'influence pas la régulation du niveau de tension de référence.

2. Procédé selon la revendication 1,
**caractérisé en ce que**
la durée impulsionnelle du signal d'émission est d'environ 100 µs, la durée de la période du signal d'émission est d'environ 1000 µs et la constante de temps de la régulation est d'environ 3 µs.

3. Procédé selon la revendication 1 ou 2,
**caractérisé en ce que**
le milieu de transmission est en verre et le signal d'émission et le signal de réception sont des signaux lumineux.

4. Dispositif pour un capteur de pluie d'un véhicule pour déterminer le mouillage d'un pare-brise, le dispositif comportant :
- une installation d'émission pour injecter un signal d'émission pulsé avec une durée d'impulsion fixe dans un milieu de transmission,
- une installation de réception (2, 13) pour recevoir un signal de réception continu ayant une partie de signal utile et une partie de signal parasite à partir du milieu de transmission,
- une installation de conversion (4, 12) pour convertir le signal de réception en une tension de sortie correspondante,
**caractérisé en ce que**
l'installation de conversion (4, 12) comporte un circuit de réaction pour réguler la tension de sortie sur un niveau de tension de référence constant, ce circuit de réaction ayant un régulateur PI (1, 11, 26, 27) dont l'entrée non inversée reçoit une tension d'alimentation fïxe et dont l'entrée inversée reçoit par l'intermédiaire d'un filtre passe-bas (5, 21, 22, 23) la tension de sortie de l'installation de conversion (4, 12),
le régulateur PI (1, 11, 26, 27) étant relié par sa sortie, par l'intermédiaire d'une résistance (14) reliée à l'installation de réception, à l'entrée de l'installation de conversion (4, 12),
la durée impulsionnelle du signal utile étant inférieure à une constante de temps du filtre passe-bas (5, 21, 22, 23) du circuit de réaction (1, 5, 11, 21, 22, 23, 26, 27) de façon que la composante de la tension de sortie correspondant à la composante de signal utile n'influence pas la régulation du niveau de tension de référence.

5. Dispositif selon la revendication 4,
**caractérisé en ce que**
la constante de temps RC du filtre passe-bas est comprise entre 3 et 5 ms.

6. Dispositif selon l'une des revendications 4 et 5,
**caractérisé en ce que**
l'installation d'émission est une photodiode travaillant dans le domaine visible ou dans le domaine infrarouge IR.

7. Dispositif selon l'une des revendications 4 à 6,
**caractérisé en ce que**
l'installation de réception (2, 13) est un photocapteur.

8. Dispositif selon l'une des revendications 4 à 7,
**caractérisé en ce que**
l'installation de conversion (4, 12) est un convertisseur d'impédance.

9. Dispositif selon la revendication 8,
**caractérisé en ce que**
le convertisseur d'impédance est un amplificateur opérationnel avec une amplification prédéfinie.

10. Dispositif selon l'une des revendications 4 à 9,
**caractérisé par**
des moyens (28, 30) pour convertir la sensibilité du dispositif.

11. Capteur de pluie comportant un dispositif pour un capteur de pluie selon l'une des revendications 4 à 10 pour détecter le degré de mouillage d'un pare-brise de véhicule automobile.
